# EUROPEAN PATENT SPECIFICATION

(11) **EP 4 177 379 B1**
(45) Date of publication and mention of the grant of the patent: **29.05.2024**
(21) Application number: 21383006.0
(22) Date of filing: 05.11.2021
(51) Int. Cl.: C25B 1/04, C25B 11/032, C25B 11/053, C25B 11/055, C25B 11/061, C23C 14/16, C23C 14/20, C23C 14/34, C25B 9/77, C25B 11/052, C25B 11/056, C25B 11/065, C25B 11/089, C25B 11/091

(54) **POROUS IONOMER FREE LAYERED METAL ALLOY ELECTROCATALYST ELECTRODE**
PORÖSE IONOMERFREIE ELEKTROKATALYTISCHE ELEKTRODE AUS EINER SCHICHTMETALLLEGIERUNG
ÉLECTRODE ÉLECTROCATALYSEUR EN ALLIAGE MÉTALLIQUE À COUCHES SANS IONOMÈRES POREUX

(43) Date of publication of application: 10.05.2023
(73) Proprietor: Consejo Superior de Investigaciones Científicas (CSIC), 41013 Sevilla (ES); Universidad de Castilla La Mancha, 02071 Albacete (ES); Fundacion Domingo Martinez, 47004 Valladolid (ES)
(72) Inventor: Yubero Valencia, Francisco, 41092 Sevilla (ES); Rodríguez González-Elipe, Agustín, 41092 Sevilla (ES); Gil Rostra, Jorge, 41092 Sevilla (ES); Espinos Manzorro, Juan Pedro, 41092 Sevilla (ES); López-Fernández, Ester, Ciudad Real (ES); De Lucas Consuegra, Antonio, Ciudad Real (ES); Gómez Sacedon, Celia, Ciudad Real (ES)
(74) Representative: López Camba, Emilia

(56) References cited:
- LÓPEZ-FERNÁNDEZ E ET AL: "Ionomer-Free Nickel-Iron bimetallic electrodes for efficient anion exchange membrane water electrolysis", CHEMICAL ENGENEERING JOURNAL, ELSEVIER, AMSTERDAM, NL, vol. 433, 23 November 2021 (2021-11-23), XP086954123, ISSN: 1385-8947, DOI: 10.1016/J.CEJ.2021.133774 [retrieved on 2021-11-23]
- ZHANG DOUDOU ET AL: "One-step preparation of optically transparent Ni-Fe oxide film electrocatalyst for oxygen evolution reaction", ELECTROCHIMICA ACTA, ELSEVIER, AMSTERDAM, NL, vol. 169, 18 April 2015 (2015-04-18), pages 402-408, XP029130863, ISSN: 0013-4686, DOI: 10.1016/J.ELECTACTA.2015.04.101
- LÓPEZ-FERNÁNDEZ ESTER ET AL: "Recent Advances in Alkaline Exchange Membrane Water Electrolysis and Electrode Manufacturing", MOLECULES, vol. 26, no. 21, 1 November 2021 (2021-11-01), page 6326, XP055919221, DE ISSN: 1433-1373, DOI: 10.3390/molecules26216326
- LÓPEZ-FERNÁNDEZ E. ET AL: "Chemistry and Electrocatalytic Activity of Nanostructured Nickel Electrodes for Water Electrolysis", ACS CATALYSIS, vol. 10, no. 11, 5 June 2020 (2020-06-05), pages 6159-6170, XP055919726, US ISSN: 2155-5435, DOI: 10.1021/acscatal.0c00856

## Description

The invention relates to a new kind of electrocatalyst to be incorporated as part of the electrodes, in the anode, in water electrolysers aimed for hydrogen production through the electrochemical splitting of water into oxygen and hydrogen. The electrocatalyst is characterized by a layered and porous structure that provides a high performance towards the oxygen evolution reaction in the absence of added ionomer. The object of the invention is framed in the field of energy.

### BACKGROUND ART

Hydrogen is a promising energy vector for a clean and sustainable energy usage for operation in domestic, transport and industrial sectors. Currently, most hydrogen production relies on the steam-methane (or other hydrocarbons) reforming. This procedure is responsible for emitting CO₂ to the atmosphere in un-manageable amounts. For this reason, alternative hydrogen production processes using environmentally friendly routes (e.g., electricity from renewable sources) with no waste emissions constitute an urgent necessity. In this context, water electrolysis using intermittent renewable energy sources is emerging as a viable alternative, even at industrial scale, to those traditional methods for hydrogen production.

Anion Exchange Membrane Water Electrolysis (AEMWE) is an emerging technology for hydrogen production. It operates at low temperatures (typically up to 80ºC) and has several advantages with respect to other more traditional electrolyser types as the reduction of membranes and electrocatalysts cost (e.g., in comparison with Proton Exchange Membrane Water Electrolysis typically requiring Pt group metals electrocatalysts) or the decrease of the problems associated to the formation of potassium carbonate in conventional alkaline electrolysis processes [J.E. Park, S.Y. Kang, S.-H. Oh, J.K. Kim, M.S. Lim, C.-Y. Ahn, Y.-H. Cho, Y.-E. Sung, High-performance anion-exchange membrane water electrolysis, Electrochim. Acta. 295 (2019) 99-106].

Nickel and nickel-transition metal alloy based electrocatalyst electrodes have demonstrated a high activity in basic medium both for the oxygen evolution reaction (OER) and for hydrogen evolution reaction (HER), the former being the most restrictive reaction due to its higher overpotential. In this regard, catalyst based on Ni alloy formulations (e.g., Fe/Ni, Mo/Ni, but not restricted to these compositions) are known to decrease the OER overpotential, resulting in a highly active and low cost electrocatalyst compared with platinum metal group catalysts. However, improving the electrode performance to make AEMWE a competitive technology entails the optimization of micro-structure, porosity, amount, chemistry/composition and electrochemical surface area of the active phase of the electrocatalyst [A. Lim, H. Kim, D. Henkensmeier, S. Jong Yoo, J. Young Kim, S. Young Lee, Y.-E. Sung, J.H. Jang, H.S. Park, A study on electrode fabrication and operation variables affecting the performance of anion exchange membrane water electrolysis, J. Ind. Eng. Chem. 76 (2019) 410-418]. Similar disclosures can be found in ZHANG DOUDOU ET AL: "One-step preparation of optically transparent Ni-Fe oxide film electrocatalyst for oxygen evolution reaction",ELECTROCHIMICA ACTA, ELSEVIER, AMSTERDAM, NL, vol. 169, 18 April 2015 (2015-04-18), pages 402-408, ISSN: 0013-4686, DOI: 10.1016/J.ELECTACTA.2015.04.101 and

LÓPEZ-FERNÁNDEZ E. ET AL: "Chemistry and Electrocatalytic Activity of Nanostructured Nickel Electrodes for Water Electrolysis",ACS CATALYSIS, vol. 10, no. 11, 5 June 2020 (2020-06-05), pages 6159-6170, US ISSN: 2155-5435, DOI: 10.1021/acscatal.0c00856

Among other requirements, electrode electrocatalysts must present high electrochemical activity and stability, be cheap and have a secure supply. From an operational point of view, it is also critical to achieve a precise control over catalyst microstructure, composition, element distribution and chemical state. For practical exploitation, to reduce the cost related to the electrocatalyst load, electrocatalysts must possess a high specific activity towards the OER and HER reactions taking place in the electrolyser. These characteristics and requirements can be optimized by the usage of appropriate preparation methods.

The most common routes to fabricate the electrodes for water electrolysis involve the incorporation of a catalyst slurry or ink into a gas diffusion layer (GDL) support. Typically, an ionomer compound is also added to the slurry or ink in order to promote the diffusion of hydroxyl groups to the anode active sites where the oxidation reaction leading to the formation of oxygen will take place. The catalysts themselves are mostly prepared as powders following wet routes as co-precipitation, hydrothermal, sol-gel, or directly incorporated into the electrode using electrodeposition methods. In these classical approaches, typical steps involve the preparation of precursor solutions, precipitation processes, washings, filtrations, dryings, calcinations, and/or milling. A clear disadvantage of these wet routes is that they involve solvents that produce unwanted wastes and imply a high number of steps, which handicap reproducibility when scaling up the manufacture procedure of the electrocatalyst.

Due to the special characteristics and constrains of the electrolyser cells, not only a good choice of material catalysts is a critical requirement, but also achieving an optimised integration of the electrocatalyst within the electrode, in the so called membrane electrode assembly (MEA) and the complete stacked cell. This makes important not only finding the best electrocatalyst composition for the anode and cathode OER and HER reactions, or the use of the most appropriate ionomer type and load, but also the best way to integrate the appropriate electrocatalyst materials in the GDL and, ultimately, the cell. Selecting the most appropriate procedure for the synthesis and integration of the electrocatalyst is therefore a critical requirement to optimize the electrocatalyst performance and hence, the cell operating capacity.

Traditional preparation methods of AEMWE catalyst electrodes using slurries or inks often involve the addition of polymeric organic ionomer molecules to increase the cell performance. The ionomer function is twofold. It serves as binder to the GDL supports and it increases the number of ion transport pathways between the electrocatalyst load and the anion exchange membrane, favouring the anion diffusion capacity up to the reaction sites. This compound influences the gas permeability and, thanks to its charged functional groups, facilitates the exchange of water and OH⁻ ion at the catalyst surface. However, ionomers can be also disadvantageous if, through electrostatic/covalent interactions, their charged groups occupy catalyst active sites, thus increasing the HER and OER operating overpotentials. Over time, ionomers may undergo chemical degradation, resulting in a deterioration of the effective catalyst-ionomer interface and, therefore, the electrochemical active surface area of the electrode available for reaction. The development of new catalyst formulations avoiding the use of said ionomers is therefore a clear need to ensure the long term operation of electrolyser cells.

### SUMMARY OF THE INVENTION

The present invention proposes the incorporation of layered metal alloys electrocatalyst into gas diffusion layer backings by means of magnetron sputtering in oblique angle deposition geometry (MS-OAD) in order to obtain an ionomer-free electrode. The resulting porous and nanostructured electrodes can be integrated in membrane electrode assemblies and, afterwards, in suitable stacks to build AEMWE electrolysers.

Claim 1 of the present invention relates to a layered electrocatalyst electrode comprising
- a macroporous gas diffusion layer and current collector material substrate in the thickness range 0.05 mm to 1.0 mm; and
- an electrocatalyst with an equivalent thickness between 0.05 µm and 5 µm, wherein said electrocatalyst layer comprising a first and a second surface, wherein the first surface is in contact with the surface of the substrate, and wherein the second surface is opposite to the first surface in the direction defined by the thickness of the electrocatalytic layer;
characterized in that
the substrate is selected from carbon paper, stainless-steel or nickel, wherein the carbon paper, stainless-steel and nickel are in the form of microfibers, sponge or mesh like structure;
wherein the electrocatalyst layer comprises a NiFe alloy with an average value between 0.5% and 30% in weight of Fe in the alloy, wherein the NiFe alloy composition of the first surface of the electrocatalyst layer is between 0.5% and 2% in weight of Fe in the alloy, and the NiFe alloy composition of the electrocatalyst layer at the second surface is between 12% and 30% in weight of Fe in the alloy;
wherein the electrocatalyst layer has a specific electrochemical active surface area (ECSA) between 1 and 100 cm²/mg with respect to the oxygen evolution reaction (OER) expressed in area per catalyst load units determined from the Nyquist plots of the electrode systems by means of electrical impedance spectroscopy measurement;
wherein the electrocatalyst layer is a mesoporous layer with a porosity between 20% and 50% as measured by Kr gas adsorption isotherm and with a pore size varying between 2 and 100 nm determined by direct quantification of Scanning Electron Microscopy pictures of the films.

The term "equivalent thickness" as used herein refers to the thickness of the NiFe alloy deposited on a flat substrate in the same deposition batch that the electrocatalysts on the GDL.

The term "electrocatalyst layer" as used herein refers to an alloy layer with a controlled composition, porosity and microstructure that is deposited onto the macroporous substrate by magnetron sputtering in an oblique angle geometry. It is the electroactive catalyst layer inducing the OER or HER reaction upon application of a polarization potential. In the present invention the pore sizes are determined by direct quantification by Scanning Electron Microscopy pictures of the films and the pore volume measured by Kr gas adsorption isotherm. This electrocatalytic layer is arranged to be in contact with an electrolyte under operating conditions through the second surface described above.

The term "macroporous" as used herein refers to an open pore structure with pore sizes in the range of 5-100 microns as determined by direct observation by means of scanning electron microscopy. The voids are defined by the arrangement of yarns or microfibers or by a sponge-like or mesh or similar structures and where the said voids have a size in the range of 5 to 100 microns.

The term "macroporous gas diffusion layer and current collector" (GDL) as used herein refers to a macroporous material that act as support of the electrocatalyst layer. It refers to the said woven-, microfiber-, mesh- or sponge- like structure of the substrates in the form of a laminate that can be made of either carbon, nickel, stainless steel or any other material stable in the basic medium where the OER takes place.

The term "electrochemical active surface area" (ECSA) as used herein refers to the equivalent specific area of the electrode material that is accessible to the electrolyte and that is used for the OER at the anode. It is measured in area per catalyst load units and it is determined according to the electrochemical double-layer capacitance method from the Nyquist plots of the electrode systems by means of electrical impedance spectroscopy measurements. It is related with the actual surface area of the mesoporous structure of the electrocatalyst layer and defines the effectiveness of a given layer to promote a specific reaction. The ECSA also can be determined from any other methods based on current voltage measurements at several voltage scan rates, the so called capacitance method. In the context of the present invention, it refers to the OER.

The electrocatalyst layer as used in the present invention is deposited on rough or macroporous randomly oriented surfaces as those of the typical GDLs formed by the agglomeration of microfibers or with a sponge like microstructure, but keeps the average mesoporosity, conferring a potentially high electrochemical performance to the electrocatalyst materials prepared in these conditions. The high porosity and high specific ECSA of the electrocatalyst layer attainable by properly controlling the deposition process are other essential conditions for an optimized performance towards OER and HER. The GDL macroporous materials selected must present a high electron conductivity, enable the out-diffusion of the gases (H₂ or O₂) from the interface between the anion exchange membrane of the AEMWE cells and the electrocatalyst layer and be highly stable in the basic operation conditions of the electrochemical cell.

A tailored in-depth distribution of porosity and composition along the electrocatalyst layer attainable by properly controlling the deposition process are additional key features of these electrocatalyst layers.

Another advantage of the electrodes manufactured by the incorporation of the said electrocatalyst layer onto the GDL substrates as claimed in the present invention is the absence of any appreciable degradation or delamination of the electrocatalyst layer from the GDL after use, clearly evidencing the great stability of the electrodes. Furthermore, this stability can be confirmed because no traces of Fe and/or Ni have been observed after performing an inductively coupled plasma analysis of the alkaline water solutions feeding the electrolyser after experiments.

When applying traditional electrode preparation methods, an ionomer is added to the catalyst ink or slurry as binder and to favour the ion transfer transport up to the reaction sites. Considering that the operation of the electrocatalyst layer of the present invention is not restricted by ion transfer mechanisms and that no delamination of the active catalyst layer has been detected after long-term operation, it appears that MS-OAD electrocatalysts do not require any binding agent to fix the catalyst layer to the GDL support. Thus, the electrocatalyst layer of the electrode of the present invention operates under an ionomer-free basis.

Another advantage of the electrocatalyst in the form of a deposited layer covering the void surfaces of the most external regions of the GDL substrate resides in the little amount of active metal phase required for operation. Electrodes prepared as described in the present invention present similar electrochemical performance than conventional electrodes prepared by wet chemical routes with, at least, one order of magnitude less active material (e.g., Ni, NiFe, etc.) than in these other cases.

Another advantage of the proposed alloy electrodes is the control of the elemental distribution in-depth within the layer structure according to different profiles, including a homogeneous distribution, a bilayer or multilayer distribution or a smoothly variable elemental profile distribution, among others. This allows tailoring the properties of the electrocatalyst layer, for example to bring in contact with the GDL support a composition more prompt to adherence and at the external zones in contact with the electrolyte a phase composition particularly active towards the OER or HER reaction. This control has also clear advantages regarding the cost of the metals since only a few atomic layers of the most expensive elements can be deposited in the outer zones to act as effective electrocatalyst in contact with the electrolyte when said electrode is in use.

Thus, in a preferred embodiment of the present invention the GDL macroporous substrate acting as backing gas diffusion layer and current collector is nickel with the form of mesh like structure, because its highest robustness against chemical degradation in basic media.

In other preferred embodiment, the stoichiometry of the alloy in the electrocatalyst layer has a homogeneous composition from first surface to the second surface; or wherein the stoichiometry of the alloy in the electrocatalyst layer has a linear compositional gradient of the percent in weight of Fe in the alloy in the direction of the layer thickness from the first surface at the interface with the GDL substrate to the second surface at the outmost external zones in contact with the electrolyte.

In other preferred embodiment, the stoichiometry of the NiFe alloy is adjusted to an average value between 8 % and 12% in weight of Fe in the alloy. This ratio ensures the homogeneous distribution of iron atoms within the nickel atomic lattice and provides the maximum current when operated to induce the OER.

In other preferred embodiment, the NiFe alloy composition of the first surface of the electrocatalyst layer is between 0.1% and 2% in weight of Fe in the alloy, and at the second outer zone is between 10% and 20% in weight of Fe in the alloy.

In other preferred embodiment, the porosity of the electrocatalyst layer has a constant porosity along the whole layer thickness with a value of between 20 and 50% of the total volume of the layer, or wherein the porosity in the electrocatalyst layer vary linearly from the first surface to the second surface. In a more preferred embodiment, the porosity of the first surface zone is between 20% and 30% and the porosity of the second surface zone is between 40% and 50%.

A varying profile of the porosity is achieved varying the gas plasma pressure during the MS deposition and/or the angle of deposition during MS-OAD.

In other preferred embodiment, the electrocatalyst at the second surface further comprises a layer of a Ni(Fe)OₓH_{y} compound. Said compound leads to an enhancement of surface reactivity. This, combined with the metallic character of the bulk of the catalyst film, a feature that diminishes the electrical resistance of the electrode, further contributes to enhance the performance of the OER electrochemical process.

The term "Ni(Fe)OₓH_{y} compound" as used herein refers to a layer of a mixed oxide-hydroxide of Fe and Ni which is deemed the active phase for the OER. This layer can be directly deposited by MS-OAD on the external surface of the NiFe electrocatalyst catalyst, but most commonly is generated from the FeNi alloy by the electrochemical cycling of the electrodes in the basic medium.

Claim 8 of the present invention is the process to obtain the layered electrocatalyst electrode characterized in that it comprises the following steps
a) placing a macroporous gas diffusion layer and current collector material substrate selected from carbon paper, stainless steel and nickel wherein the carbon paper, stainless-steel and nickel are in the form of microfibers, sponge or mesh like structure in a holder of a vacuum chamber of a magnetron sputtering deposition apparatus;
b) placing nickel and iron as a target or targets, or a NiFe alloy target or targets in the magnetron sputtering head located in the deposition apparatus of the step (a), wherein the target has a shape selected from disc, circular, square, cylinder and rectangle, and wherein the distance between the target and the substrate is between 2 cm and 30 cm and wherein the normal to the substrate surface is located at an angle of at least 70° with respect to the normal to the target surface at the race track formed on its surface due to sputtering, as carried out in a MS-OAD configuration;
c) making vacuum in the chamber of step (b) until a base pressure of 4·10⁻⁶ mbar or below is achieved, introducing Ar gas at a flow between 20 and 40 standards cubic centimetre per minute and process pressure of 5·10⁻³ mbar and igniting the magnetron plasma by applying a pulsed DC power of between 50 W and 3000 W and a frequency of between 80 and 200 kHz to the target while the holder is rotating at a rotational speed between 1 and 10 turns per minute, whereby a layer of the NiFe electrocatalyst electrode is deposited;
   and optionally
d) depositing or generating on the layered electrocatalyst electrode obtained in step (d) a layer of Ni(Fe)OₓH_{y} compound by a technique selected from MS-OAD or by electrochemical cycling of the electrode.

Magnetron sputtering deposition technology is a classical physical vapour deposition procedure widely utilized in the industry for the preparation of compact layers for a large variety of applications in optics, tribology, hard coatings, etc. This invention claims that it is also an optimum choice for the fabrication of porous and nanostructured electrocatalyst layers suitable for their integration into highly performant AEMWE cells. In particular, when this method is utilized in an oblique angle deposition configuration (MS-OAD) and certain operation conditions, it provides nanostructured and highly porous electrocatalyst layers which, gifted with a high electrochemical active surface area, result very appropriate for their incorporation onto GDL as electrodes in AEMWE. The method is highly reproducible, scalable to large deposition areas, does not produce residues and works at room temperature. A careful adjustment of the deposition geometry and the plasma gas pressure during MS-OAD renders mesoporous nanostructured materials with a strict control of the composition, load and microstructure. The resulting nanostructured layer deposited onto the GDL facilitates the flow of liquid reactants (basic aqueous solution) and the release of the produced gases (H₂, O₂) through the nanometric pathways existing in the catalyst deposits decorating the fibrous/macroporous GDL backing. Another advantage of the process of the present invention is to prepare in-depth composition variable electrocatalyst layers with a tailored composition and porosity distributions in depth.

Thus, a preferred embodiment of the process of the present invention, the target has a disc shape with a diameter size of between 50 mm and 100 mm, and wherein the pulse DC power of step (c) is between 50 W and 300 W and a frequency of between 80 and 140 kHz.

In other preferred embodiment the nickel/iron target or targets is a nickel with a shape selected from disc, circular, square, cylinder and rectangle, more preferably with circular shape with a diameter between 50 mm and 100 mm with iron strips with a width of between 1 mm and 2 mm and a thickness between 0.2 and 0.3 mm, axially wrapped on the disc surface.

In other preferred embodiment of the process, the target is a NiFe alloy with between 2.0% and 20% in weight of Fe.

To achieve the expected activity of the porous electrocatalyst, it is fabricated by magnetron sputtering at oblique angles. Due to the fact that MS-OAD induces intrinsically inhomogeneous deposits on large substrates, substrate movement during deposition is mandatory to achieve homogeneous loads on substrates. There are various possibilities to achieve a homogeneous deposition.

In a first MS-OAD configuration option, the experimental set-up consists of a rotatable sample holder whose axis is placed normal to the main direction of particle flux from either the magnetron heads. The GDL backing electrode is attached to the sample holder and continuously rotated during the deposition of the mesoporous electrocatalyst. In these conditions the microfiber, sponge or mesh like structure of the textured substrate support becomes decorated with a mesoporosus NiFe electrocatalyst layer. On flat substrates, this geometrical configuration and realization procedure renders vertically oriented mesoporous nanocolumnar structures.

In another preferred embodiment of the process, the deposition of the electrocatalyst is done in even number of steps at a fixed perpendicular orientation of the GDL substrate with respect to a sputtering target, and azimuthally turning the sample holder 180º for each deposition step. By this configuration the substrate surface normal forms an oblique angle with respect to a perpendicular line to the target. This second option produces a zig-zag microstructure when deposited on flat substrates. When using structured GDL supports, the result is a nanostructured layer covering the pores surfaces at the shallow regions of the supports and a homogeneous thickness distribution of the electrocatalyst layer on the whole substrate.

In another configuration, generally using a rectangular sputtering target, a flexible GDL backing can be attached to a cylindrical sample holder that turns continuously around its shaft axis during deposition. This latter configuration is compatible with roll-to-roll procedures and permits the optimization of the deposition of material onto the substrate. In these conditions, the main flow of material from the sputtered target will reach the GDL substrate at averaged local oblique geometries, thus warrantying a high mesoporosity.

Other possible realizations of the MS-OAD process can also be used to get the desired porous microstructure up to 50% of the volume of the layer as the use of slits and linear movable substrates or the twisting of substrates at giving moments of the deposition in order to homogenize the electrocatalyst layer thickness over the entire substrate. The use of slits serves to select depositing particles coming from the target within a certain solid angle and arriving to the substrate at an oblique angle with respect to its surface normal. An inconvenient of this configuration is that only a small fraction of the sputtered material coming from the target passes through the slit up to the substrate.

Claim 10 of the present invention is a membrane electrode assembly (MEA) characterized in that it comprises two electrodes, at least one of said electrode is the electrode described above in the present invention, and an anion exchange membrane.

The term "membrane electrode assembly (MEA)" as used herein refers to the anion exchange membrane sandwiched between an anode and a cathode, with anode/cathode consisted of GLD with corresponding deposited electrocatalyst optimised for OER/HER, respectively. The whole ensemble is embodied and pressed between to bipolar metal plates enabling the access of the electrolyte, generally a KOH aqueous solution with a given concentration, typically 1.0 M, and the release of the produced gases (O₂ at the anode, H₂ at the cathode)

In a preferred embodiment of the MEA,
- one of the electrodes is the electrode described above in the present invention, and it is suitable to act as an anode; and
- second electrode is a porous Ni layer acting as electrocatalysts and deposited following the same MS-OAD procedure from a pure Ni target onto another backing gas diffusion layer and current collector material that is suitable to act as a cathode;
wherein the assembly between anode and cathode is made by an anion exchange membrane and electrodes are connected to an external electrical circuit applying the desired difference of voltage between anode and cathode, generally from 1.5 to 2.5 V.

Depending on the size of the electrodes and the efficiency of the process, current densities up to 1500 mA cm⁻² can be produced. The MEAs operating temperature is, generally between 60 and 80 ºC

Claim 12 of the present invention is an Anion Exchange Membrane Water Electrolysis (AEMWE) electrolyser characterized in that it comprises a stacking of at least two MEA units connected electrically in series in a compact system. In a preferred embodiment, the Anion Exchange Membrane Water Electrolysis (AEMWE) electrolyser further comprises a stacking of more than five MEAs arranged in a compact system in a way such that the electrodes are electrically connected in series and the electrolyte circulates in parallel through the various anode and cathode compartments and the gases are released separately through outlet tubing.

The term "AEMWE electrolysers" as used herein refers to the compact stacking system of several MEAs described before, with the appropriate shielding gaskets and plates and gas inlets and outlets, etc. and where the aqueous electrolyte is adjusted to basic conditions, generally to pH=10 or above

Claim 14 of the present invention is a method for hydrogen production characterized in that it comprises the following steps
i. feeding the AEMWE electrolyser described above in the present invention with a KOH aqueous solution between 0.1 M and 4 M at a temperature of between 40 ºC and 85ºC;
ii. applying a polarization voltage between 1.8 V and 2.2 V to each one of the MEA unit cells, electrically connected in series in the stack.

In a preferred embodiment, the temperature in step i) is between 60 ºC and 80 ºC.

An advantage of the so built AEMWE electrolysers is their operation without adding an ionomer to the electrocatalysts, thus avoiding operational problems related with degradation or contamination of the electrodes and, therefore facilitating a long operational time. Another, a significant reduction in the amount of active phase in the electrocatalysts and the consequent reduction of associated costs.

Claim 15 of the present invention is the use of the layered electrocatalyst electrode described above in the present invention as an anode in AEMWE electrolysers.

Unless otherwise defined, all technical and scientific terms used herein have the same meaning as commonly understood by one of ordinary skilled in the art to which this invention belongs. Throughout the description and claims the word "comprise" and its variations are not intended to exclude other technical features, additives, components, or steps. Additional objects, advantages and features of the invention will become apparent to those skilled in the art upon examination of the description or may be learned by practice of the invention. The following examples, drawings and sequence listing are provided by way of illustration and are not intended to be limiting of the present invention.

### BRIEF DESCRIPTION OF THE DRAWINGS

**Fig. 1****.** Scheme of the geometry of the MS-OAD process used for the fabrication of electrocatalysts in examples 1 to 5 and comparative example 6
**Fig. 2****.** Diffractograms of the as prepared NiFe bimetallic electrocatalysts used as anodes in examples 1 to 5 and comparative example 6
**Fig. 3****.** Expanded view of diffractograms around Ni(220) diffraction peak of the as prepared NiFe bimetallic electrocatalysts used as anodes in examples 1 to 5 and comparative example 6
**Fig. 4****.** Cyclic voltammetry experiments carried out for electrocatalysts fabricated in examples 1 to 5 and comparative example 6 in a three-electrode glass cell at room temperature, 1.0 M KOH electrolyte and 20 mV/s of scan rate.
**Fig. 5****.** SEM images in normal view of *EE-10%Fe-Ni* (*EE*, electrocatalyst electrode) electrocatalyst as-prepared and after its usage in the three-electrode glass cell.
**Fig. 6****.** Temperature. Linear sweep voltammetry characteristic of the electrocatalyst prepared in example 2 and integrated in a single MEA electrolysis cell according to experimental example 4 at 40 and 60ºC operation temperatures.
**Fig. 7****.** Ionomer. Linear sweep voltammetry characteristic of the electrocatalyst prepared in example 2 and integrated in a single MEA electrolysis cell with and without ionomer at 40ºC operation temperature.
**Fig. 8****.** Stability. 1^{st} and 200^{th} cycle linear sweep voltammetry characteristic of the electrocatalyst prepared in example 2 and integrated in a single MEA electrolysis cell according to experimental example 4 at 40ºC operation temperature.
**Fig. 9****.** Stability. Constant-current chronopotentiometric measurement acquired at 400 mA/cm2 and 40ºC for 2 days of the electrocatalyst prepared in example 2 and integrated in a single MEA electrolysis cell at 40ºC operation temperature.

### Examples

### Example 1. Production of electrocatalyst electrode EE-(5%Fe)Ni for AEMWE electrolyser

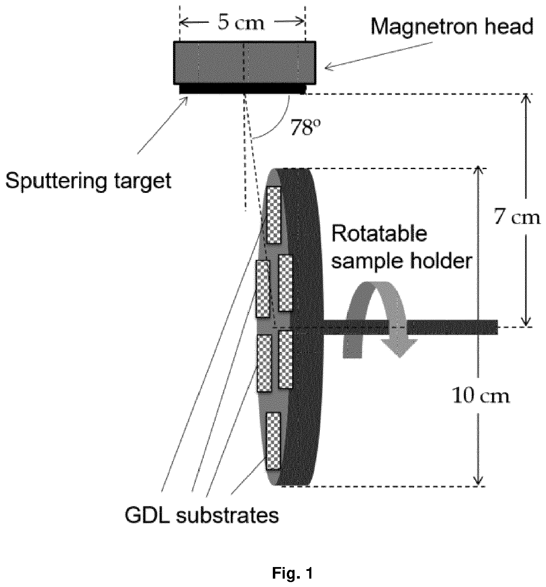

A NiFe bimetallic electrocatalyst electrode of the present invention was prepared at room temperature (25 ºC) by MS-OAD with a geometrical arrangement as described in Figure 1. A circular nickel sputtering target (GoodFellow Cambridge Ltd., 99.9 at. %, 50 mm diameter) with one axially wrapped iron strip (GoodFellow Cambridge Ltd., 99.5 at. %, 1.5 mm width, 0.25 mm thickness) was used as source of the bimetallic alloy. The sputtering target was operated using a pulsed DC power supply (AE Pinnacle+) at 150 W and a frequency of 120 kHz. Carbon paper GDL baking electrodes (TGP-H-90, Fuel cell Earth) were used as substrates.

Similar electrocatalyst layers can be prepared substituting the Ni target with Fe strips by a FeNi alloy target with the desired composition.

The carbon paper substrate was placed on a circular rotatable sample holder of 10 cm diameter. This holder was positioned in an angle of ~78° with respect the surface of the sputtering target and was continuously rotating at 5 turns per minute to homogenise the thickness and microstructure of deposited films. This configuration is also compatible with the deposition from two targets located in similar radial positions with respect to the rotating disc. Argon was used as plasma gas. A flow of 30 sccm (standard cubic centimetres per minute) was dosed in the preparation chamber yielding a process pressure of 5·10⁻³ mbar. The base pressure in the system was 2·10⁻⁶ mbar. Time of deposition of 100 minutes was required to achieve the desired amount of electrocatalyst. The deposition rate was about 5 nm equivalent thickness of deposited material per minute.

Carbon paper (TGP-H-90, Fuel Cell Earth) was used as support of the electrocatalysts. In addition, polished silicon wafers were also used as substrates for cross-section microscopy analysis of the different nickel based thin films. We define equivalent thickness as the physical thickness determined by cross-section SEM analysis for the thin films deposited simultaneously on a flat silicon wafer substrate. In these conditions, the iron content in the nanostructured bimetallic NiFe alloy deposit was about 5 % by weight.

### Example 2. Production of electrocatalyst electrode EE-(10%Fe)Ni for AEMWE electrolyser

An electrocatalyst electrode for AEMWE electrolyser was fabricated in the same manner as in example 1, except that the number of iron strips wrapped to the Ni sputtering target were two evenly distributed. In these conditions the iron content in the nanostructured bimetallic NiFe alloy deposit was about 10% by weight.

Similar electrocatalyst layers can be prepared substituting the Ni target with Fe strips by a FeNi alloy target with the desired composition.

### Example 3. Production of electrocatalyst electrode EE-(15%Fe)Ni for AEMWE electrolyser

An electrocatalyst electrode for AEMWE electrolyser was fabricated in the same manner as in example 1, except that the number of iron strips wrapped to the Ni sputtering target were three evenly distributed. In these conditions, the iron content in the nanostructured bimetallic NiFe alloy deposit was about 15% by weight.

Similar electrocatalyst layers can be prepared substituting the Ni target with Fe strips by a FeNi alloy target with the desired composition.

### Example 4. Production of electrocatalyst electrode EE-(20%Fe)Ni for AEMWE electrolyser

An electrocatalyst electrode for AEMWE electrolyser was fabricated in the same manner as in example 1, except that the number of iron strips wrapped to the Ni sputtering target were four evenly distributed. In these conditions, the iron content in the nanostructured bimetallic NiFe alloy deposit was about 20% by weight.

Similar electrocatalyst layers can be prepared substituting the Ni target with Fe strips by a FeNi alloy target with the desired composition.

### Example 5. Production of electrocatalyst electrode EE-(30%Fe)Ni for AEMWE electrolyser

An electrocatalyst electrode for AEMWE electrolyser was fabricated in the same manner as in example 1, except that the number of iron strips wrapped to the Ni sputtering target were six evenly distributed. In these conditions, the iron content in the nanostructured bimetallic NiFe alloy was about 30% by weight.

Similar electrocatalyst layers can be prepared substituting the Ni target with Fe strips by a FeNi alloy target with the desired composition.

### Example 6. Production of electrocatalyst electrode EE-Ni for AEMWE electrolyser

A reference nanostructured electrocatalyst electrode for AEMWE electrolyser was fabricated in the same manner as in example 1, except that there were no iron strips wrapped to the Ni sputtering target.

### Example 7. Experimental example about comparative X-ray diffraction analyses

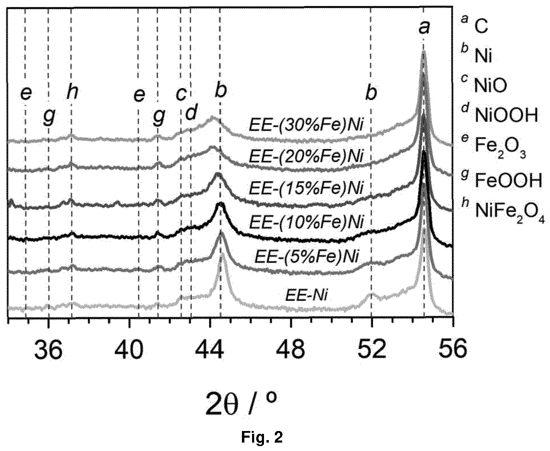

The electrocatalyst electrodes fabricated in Examples 1 to 5 and comparative example 6 were analysed by X-ray diffraction (XRD). Figure 2 shows diffractograms of the as prepared NiFe bimetallic anodes. They serve as fingerprint analysis of the different prepared electrocatalysts. They illustrate that the catalysts are mostly polycrystalline with small crystallite grain size (weak diffraction peaks are detected) as a consequence that the deposition process is at room temperature and that the iron atoms are incorporated within the nickel atomic network.

The diffractograms in Figure 2 depict a characteristic intense diffraction peak at 54.6º attributed to the carbon paper used as substrate. In addition, two smaller diffraction peaks at approximately 44.5º and 51.9º, are attributed to metallic nickel or a Ni containing alloy.

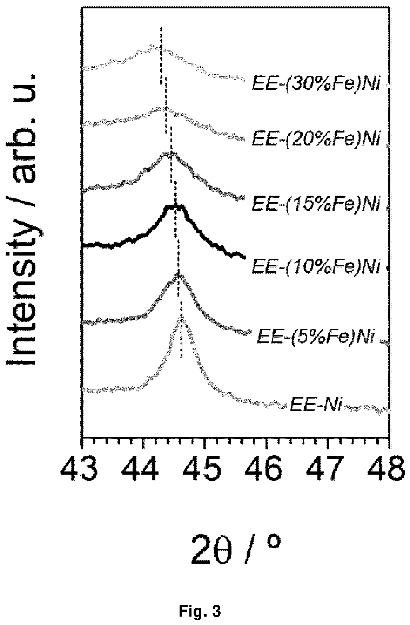

An enlarged view of the peaks at 44.5º, due to the Ni(220) reflections in a metallic based Ni network, is shown in Figure 3. It is apparent that their intensities decrease, their widths increase and their positions shift as the iron content in the samples increases. These effects are due to the random incorporation of iron atoms within the face centred cubic (fcc) structure of Ni, forming a kind of alloy. The lack of diffracted reflexions attributable to metallic Fe confirms the incorporation of Fe into the Ni structure. Overall, this XRD analysis shows that bimetallic electrodes consist of a metallic alloy with small crystallite grain size.

### Example 8. Experimental example about electrochemical characterization of electrocatalyst electrodes in half cell configuration

The electrocatalysts electrodes prepared in examples 1 to 5 and comparative example 6 were evaluated for performance towards the OER in a three-electrode glass cell (i.e., half-cell configuration).

This cell integrates a working anode (1.0 cm² geometric area), an Ag/AgCI reference electrode (KCI, 3M, Metrohm^{®}) and a platinum foil (Metrohm^{®}) counter electrode.

The electrochemical characterization consists of cyclic voltammetry (CV) measurements. They were carried out with an Autolab PGSTAT30-ECOCHEMIE potentiostat/galvanostat. All measurements were performed at room temperature and 1.0 M KOH electrolyte aqueous solution. A nitrogen gas flow was bubbled for at least 20 minutes prior to test the electrodes and then it was kept bubbling during the experiments. The voltage range in the CV measurements was from 0.00 to +750 mV vs. Ag/AgCI. CV and the scan rate was 20 mV/s.

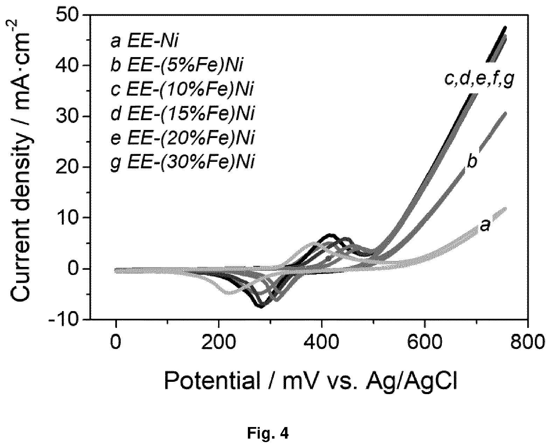

Figure 4 shows cyclic voltammetry experiments carried out for electrodes fabricated in examples 1 to 5 and comparative example 6 in a three-electrode glass cell at room temperature, 1.0 M KOH electrolyte and 20 mV/s of scan rate.

As shown in Figure 4, the incorporation of iron has a positive effect in the OER activity, leading to a significant increase in current density values (magnitude proportional to the O₂ formation at the anode) with respect to those obtained for Ni electrocatalyts fabricated in comparative example 6. The improvement in the electrocatalytic activity due to the incorporation of iron reflects in that the overpotential value required to reach 10 mA/cm² was the lowest (i.e., 307 mV) for the *EE-(10%Fe)Ni* anode.

This enhancement is related to the substitution of Fe⁺³ for Ni⁺² sites in Ni(OH)₂ and NiOOH, leading to new Ni-O local environments with a superior activity for the OER. Figure 4 shows that the addition of increasing amounts of Fe to the Ni catalyst favours the OER activity until a 10% in weight of Fe in the alloy becomes incorporated to the Nickel structure. Then, for iron incorporation percentages higher than 10% by weight, a plateau in the response towards OER is achieved.

### Example 9. Experimental example about SEM analyses of as prepared and used electrocatalysts

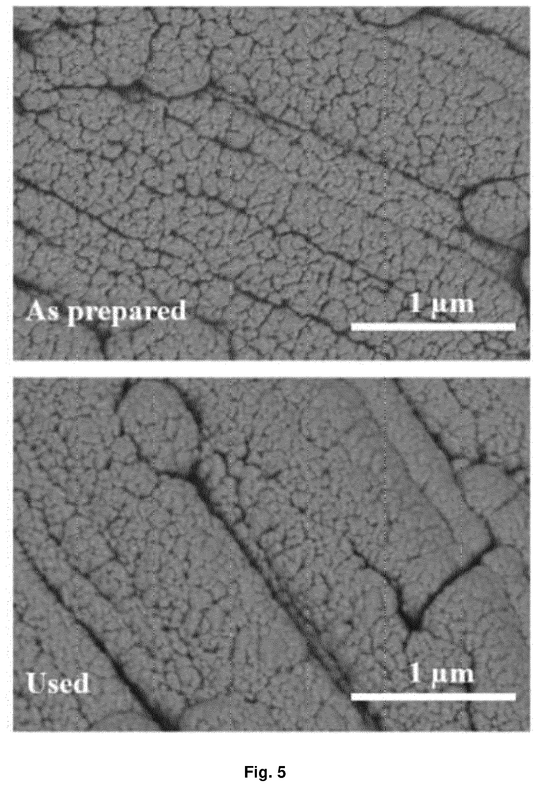

The electrocatalyst electrode fabricated in Example 2 was analysed by scanning electron microscopy as prepared and after operation in half cell configuration Figure 5 shows SEM analysis of the used electrodes revealed a similar morphology and microstructure than that of the as prepared electrodes. This observation discards delamination of the catalyst from the backing support in the used electrodes and confirms the stability of bimetallic electrodes.

### Example 10. Experimental example about production of a complete electrolysis cell with a single MEA

*EE-(10%Fe)Ni* electrode (catalyst load of 0.35 mg/cm², equivalent thickness 540 nm) as described in Example 2 was used as anode and a *EE-Ni* electrode (load of 0.38 mg cm⁻², equivalent thickness 540 nm), as described in comparative example 1, was used as cathode.

Catalyst films were deposited on carbon paper with a geometric area of 6.25 cm².

The electrodes were separated by an anion exchange membrane (Fumapem^{®} FAA-3-50 supplied by Fuel Cell Store). The geometric area of the electrodes in the MEA was 5 cm² and the catalyst load was determined by weighing before and after the MS-OAD deposition.

Prior to use, the Fumapem^{®} FAA-3-50 anion exchange membrane was immersed in a 1.0 M KOH solution for 24 hours at room temperature to activate it, i.e., to replace Br⁻ functional groups in the pristine membrane by OH⁻ groups.

Nickel bipolar plates with flow channels were used as current collectors and distributors of reactants and products. Anode and cathode reservoirs were fed with KOH water electrolyte solutions with 2 ml/min flow rate. A peristaltic pump (Pump drive 5001, Heidolph) was used to impulse the electrolyte solutions from two independent 1.0 litre buffer compartments to the electrode reservoirs recirculating the streams. Teflon gaskets were used to prevent gas leakage and to avoid short-circuiting. The bolt torque applied to seal the cell was chosen to optimize the electrochemical performance of the cell.

### Example 11. Experimental example about electrochemical characterization of a MEA: performance vs operation temperature

The electrocatalyst prepared in example 2 was evaluated for electrochemical properties towards hydrogen production in a complete electrolysis cell formed by a single MEA as described in experimental Example 10.

The electrochemical measurements of the complete AEMWE cell were carried out with the Autolab potentiostat/galvanostat. Experiments consisted of linear sweep voltammetries (LSV) varying the potential from 1.0 to 2.2 V with a scan rate of 5 mV/s. at 40 and 60 ºC process temperatures.

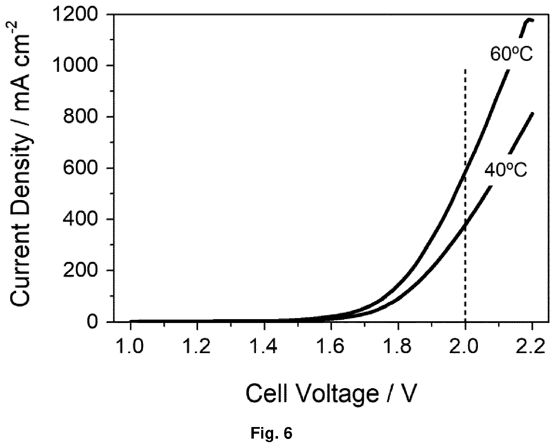

Figure 6 shows the linear sweep voltammetry characteristic of the said cell at 40 and 60 ºC operation temperature.

### Example 12. Experimental example about electrochemical characterization of a MEA: performance vs ionomer incorporation within the electrodes

The electrocatalyst prepared in example 2 was evaluated for electrochemical properties towards hydrogen production in a membrane electrode assembly with identical conditions that in experimental example 10 except that an ionomer was added on top of the electrocatalyst prior to the MEA assembly.

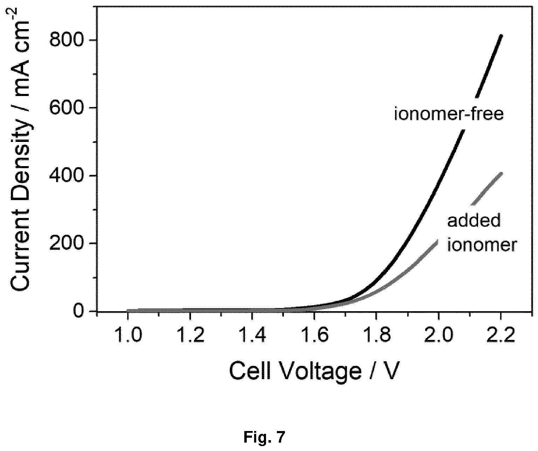

Figure 7 shows the current density vs polarization voltage characteristic of the said cell. A significant decrease of performance was attributed to the addition of ionomer to the cell

### Example 13. Experimental example about stability of an electrocatalyst incorporated into MEA

The electrocatalyst prepared in example 2 and incorporated in a MEA as described in experimental example 10 was evaluated for stability in operation conditions.

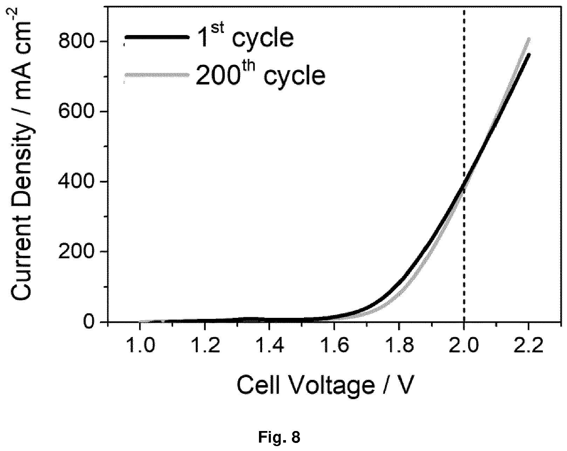

Aging experiments consisted of cyclic voltammetry measurements (200 I-V cycles, performed with scan rate of 50 mV/s at 40 ºC). Figure 8 shows that not significant variation of initial characteristic is observed, thus certifying the stability of the cell.

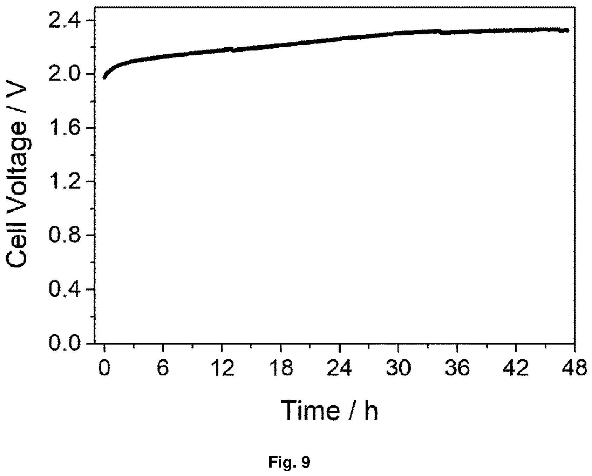

The constant-current chronopotentiometric experiments consist of measuring the voltage output of the cell setting the density current at 400 mA/cm² a 40ºC for 2 days. Figure 9 shows that only weak increase of voltage occurs over time (about 5 mV/hour), thus certifying the stability of the cell.

## Claims

1. A layered electrocatalyst electrode comprising
• a macroporous gas diffusion layer and current collector material substrate in the thickness range 0.05 to 1.0 mm; and
• an electrocatalyst with an equivalent thickness between 0.05 µm and 5 µm, wherein said electrocatalyst layer comprising a first and a second surface, wherein the first surface is in contact with the surface of the substrate, and wherein the second surface is opposite to the first surface in the direction defined by the thickness of the electrocatalytic layer;
**characterized in that**
the substrate is selected from carbon paper, stainless-steel or nickel, wherein carbon paper, stainless-steel and nickel are in the form of microfibers, sponge or mesh like structure;
wherein the electrocatalyst layer comprises a NiFe alloy with an average value between 0.5% and 30% in weight of Fe in the alloy, wherein the NiFe alloy composition of the first surface of the electrocatalyst layer is between 0.5% and 2% in weight of Fe in the alloy, and the NiFe alloy composition of the electrocatalyst layer at the second surface is between 12% and 30% in weight of Fe in the alloy;
wherein the electrocatalyst layer has a specific electrochemical active surface area between 1 and 100 cm²/mg with respect to the oxygen evolution reaction expressed in area per catalyst load units determined from the Nyquist plots of the electrode systems by means of electrical impedance spectroscopy measurement;
wherein the electrocatalyst layer is a mesoporous layer with a total porosity between 20% and 50% measured by Kr gas adsorption isotherm and with a pore size varying between 2 and 100 nm determined by direct quantification on Scanning Electron Microscopy pictures of the films.

2. Layered electrocatalyst electrode according to claim 1, wherein macroporous substrate as backing gas diffusion layer and current collector is nickel with the form of mesh like structure.

3. Layered electrocatalyst electrode according to any claims 1 or 2, wherein the stoichiometry of the alloy in the electrocatalyst layer has a homogeneous composition from first surface to the second surface; or wherein the stoichiometry of the alloy in the electrocatalyst layer has a linear compositional gradient of the percent in weight of Fe in the alloy in the direction of the layer thickness from the first surface in contact with the GDL substrate to the second surface outmost external zones.

4. Layered electrocatalyst electrode according to any claims 1 to 3, wherein NiFe alloy has an average value between 8 % and 12 % in weight of Fe in the alloy.

5. Layered electrocatalyst electrode according to any claims 1 to 4, wherein the NiFe alloy composition of the first surface of the electrocatalyst layer is between 0.1% and 2%. in weight of Fe in the alloy, and at the second outer zone is between 10% and 20% in weight of Fe in the alloy.

6. Layered electrocatalyst electrode according to any claims 1 to 5, wherein the porosity of the electrocatalyst layer has a constant porosity along the whole layer thickness with a value of between 20 and 50% of the total volume of the layer; or wherein the porosity in the electrocatalyst layer vary linearly from the first surface to the second surface.

7. Layered electrocatalyst electrode according to any claims 1 to 6, wherein the electrocatalyst second surface further comprises a layer of a Ni(Fe)OₓH_{y} compound.

8. A process to obtain the layered electrocatalyst electrode according to any of claims 1 to 7 **characterized in that** it comprises the following steps
a) placing a macroporous gas diffusion layer and current collector material substrate selected from carbon paper, stainless steel of nickel, wherein the carbon paper, stainless-steel and nickel are in the form of microfibers, sponge or mesh like structure as substrate in a holder of a vacuum chamber of a magnetron sputtering deposition apparatus;
b) placing nickel and iron as a target or targets, or a NiFe alloy target in the magnetron sputtering head located in the deposition apparatus of the step (a), wherein the target has a shape selected from disc, circular, square, cylinder and rectangle, and wherein the distance between the target and the substrate is between 2 cm and 30 cm and wherein the normal to the substrate surface is located at an angle of at least 70° with respect to the normal to the target surface at the race track formed on its surface due to sputtering in a MS-OAD configuration;
c) making vacuum in the chamber of step (b) until a base pressure of 4·10⁻⁶ mbar or below is achieved, introducing Ar gas at a flow between 20 and 40 standards cubic centimetre per minute and process pressure of 5·10⁻³ mbar and igniting the magnetron plasma by applying a pulsed DC power of between 50 W and 3000 W and a frequency of between 80 and 200 kHz to the target while the holder is rotating at a rotational speed between 1 and 10 turns per minute, whereby a layer of the NiFe electrocatalyst electrode is deposited;
and optionally
d) depositing or generating on the layered electrocatalyst electrode obtained in step (d) a layer of Ni(Fe)OₓH_{y} compound by a technique selected from MS-OAD or by electrochemical cycling of the electrode.

9. Process according to claim 8, wherein the nickel/iron target or targets is a nickel with a shape selected from disc, square, cylinder and rectangle, more preferably with circular shape with a diameter between 50 and 100 mm with iron strips with a width of between 1 mm and 2 mm and a thickness of between 0.2 and 0.3 mm, axially wrapped on the disc surface.

10. A metal electrode assembly **characterized in that** it comprises two electrodes, at least one of said electrode is the layered electrocatalyst electrode described in anyone of claims 1 to 7.

11. A metal electrode assembly according to claim 10, wherein
• one of the electrodes is the layered electrocatalyst electrode, and it is suitable to act as an anode; and
• second electrode is a porous Ni layer acting as electrocatalysts and deposited following the same MS-OAD procedure onto another backing gas diffusion layer and current collector material that is suitable to act as a cathode;
wherein the assembly between anode and cathode is made by an anion exchange membrane and electrodes are connected to an external electrical circuit applying the desired difference of voltage between anode and cathode, generally from 1.5 to 2.5 V.

12. An AEMWE electrolyser **characterized in that** it comprises a stacking of at least two MEA units according to any claims 10 or 11 connected electrically in series in a compact system.

13. An AEMWE electrolyser according to claim 12, wherein further comprises a stacking of more than five MEA arranged in a compact system in a way such that the electrodes are electrically connected in series and the electrolyte, circulates in parallel through the various anode and cathode compartments and the gases released separately through inlet and outlet tubing.

14. A method for hydrogen production **characterized in that** it comprises the following steps
i. feeding the Anion Exchange Membrane Water Electrolysis electrolyser described in anyone claims 10 or 11 with a KOH solution between 0.1 M and 4 M at a temperature of between 40 ºC and 85ºC, preferably the temperature in step i) is between 60 and 80º;
ii. applying a polarization voltage of between 1.8 V and 2.2 V to each one of the metal electrode unit cells, electrically connected in series in the stack.

15. Use of the layered electrocatalyst electrode according to any claims 1 to 7 as an anode in water electrolysers.

## Patentansprüche

1. Elektrokatalytische Elektrode aus einer Schichtmetalllegierung, umfassend
• eine makroporöse Gasdiffusionsschicht und ein Substrat aus Stromkollektormaterial im Dickenbereich von 0,05 bis 1,0 mm; und
• einen Elektrokatalysator mit einer äquivalenten Dicke zwischen 0,05 pm und 5 pm, wobei die elektrokatalytische Schicht eine erste und eine zweite Oberfläche umfasst, wobei die erste Oberfläche mit der Oberfläche des Substrats in Kontakt ist und wobei die zweite Oberfläche der ersten Oberfläche in der durch die Dicke der elektrokatalytischen Schicht definierten Richtung gegenüberliegt;
**dadurch gekennzeichnet, dass**
das Substrat ausgewählt ist aus Kohlepapier, Edelstahl oder Nickel, wobei Kohlepapier, Edelstahl und Nickel in Form von Mikrofasern, Schwamm oder netzartiger Struktur vorliegen;
wobei die elektrokatalytische Schicht eine NiFe-Legierung mit einem durchschnittlichen Wert zwischen 0,5 und 30 Gew.-% Fe in der Legierung umfasst, wobei die Zusammensetzung der NiFe-Legierung der ersten Oberfläche der elektrokatalytischen Schicht zwischen 0,5 und 2 Gew.-% Fe in der Legierung beträgt und die Zusammensetzung der NiFe-Legierung der elektrokatalytischen Schicht an der zweiten Oberfläche zwischen 12 und 30 Gew.-% Fe in der Legierung beträgt;
wobei die elektrokatalytische Schicht eine spezifische elektrochemisch aktive Oberfläche zwischen 1 und 100 cm²/mg in Bezug auf die Sauerstoffentwicklungsreaktion, ausgedrückt in Fläche pro Katalysatorbeladungs-Einheiten, aufweist, die aus den Nyquist-Diagrammen der Elektrodensysteme mittels einer Messung der elektrochemischen Impedanzspektroskopie bestimmt wird;
wobei die elektrokatalytische Schicht eine mesoporöse Schicht ist, mit einer Gesamtporosität zwischen 20 % und 50 %, gemessen über Kr-Gasadsorptionsisotherme, und mit einer Porengröße zwischen 2 und 100 nm, bestimmt durch direkte Quantifizierung auf Rasterelektronenmikroskop-Abbildungen der Filme.

2. Elektrokatalytische Elektrode aus einer Schichtmetalllegierung nach Anspruch 1, wobei das makroporöse Substrat als Gasdiffusionsschicht und Stromkollektor Nickel in Form einer netzartigen Struktur ist.

3. Elektrokatalytische Elektrode aus einer Schichtmetalllegierung nach einem der Ansprüche 1 oder 2, wobei die Stöchiometrie der Legierung in der elektrokatalytischen Schicht eine homogene Zusammensetzung von der ersten Oberfläche zur zweiten Oberfläche aufweist; oder wobei die Stöchiometrie der Legierung in der elektrokatalytischen Schicht einen linearen Zusammensetzungsgradienten des Gewichtsprozentsatzes von Fe in der Legierung in der Richtung der Schichtdicke von der ersten Oberfläche in Kontakt mit dem GDL-Substrat zu den äußersten Außenbereichen der zweiten Oberfläche aufweist.

4. Elektrokatalytische Elektrode aus einer Schichtmetalllegierung nach einem der Ansprüche 1 bis 3, wobei die NiFe-Legierung einen durchschnittlichen Wert zwischen 8 Gew.-% und 12 Gew.-% Fe in der Legierung aufweist.

5. Elektrokatalytische Elektrode aus einer Schichtmetalllegierung nach einem der Ansprüche 1 bis 4, wobei die NiFe-Legierungszusammensetzung der ersten Oberfläche der elektrokatalytischen Schicht zwischen 0,1 Gew.-% und 2 Gew.-% Fe in der Legierung und im zweiten Außenbereich zwischen 10 Gew.-% und 20 Gew.-% Fe in der Legierung beträgt.

6. Elektrokatalytische Elektrode aus einer Schichtmetalllegierung nach einem der Ansprüche 1 bis 5, wobei die Porosität der elektrokatalytischen Schicht eine konstante Porosität entlang der gesamten Schichtdicke mit einem Wert zwischen 20 und 50 % des Gesamtvolumens der Schicht aufweist; oder wobei die Porosität in der elektrokatalytischen Schicht von der ersten Oberfläche zur zweiten Oberfläche linear variiert.

7. Elektrokatalytische Elektrode aus einer Schichtmetalllegierung nach einem der Ansprüche 1 bis 6, wobei die zweite Oberfläche des Elektrokatalysators ferner eine Schicht einer Ni(Fe)OₓH_{y} -Verbindung umfasst.

8. Verfahren zur Herstellung der elektrokatalytischen Elektrode aus einer Schichtmetalllegierung nach einem der Ansprüche 1 bis 7, **dadurch gekennzeichnet, dass** es die folgenden Schritte umfasst
a) Anordnen einer makroporösen Gasdiffusionsschicht und eines Stromkollektor-Materialsubstrats, ausgewählt aus Kohlepapier, Edelstahl oder Nickel, wobei das Kohlepapier, der Edelstahl und Nickel in Form von Mikrofasern, Schwamm oder einer netzartigen Struktur als Substrat in einer Halterung einer Vakuumkammer einer Magnetron-Sputterdepositions-Vorrichtung vorliegen;
b) Platzieren von Nickel und Eisen als ein oder mehrere Target/s oder ein NiFe-Legierungs-Target in dem Magnetron-Sputterkopf, der sich in der Depositionsvorrichtung des Schritts (a) befindet, wobei das Target eine Form aufweist, die aus einer Scheibe, einem Kreis, einem Quadrat, einem Zylinder und einem Rechteck ausgewählt ist, und wobei der Abstand zwischen dem Target und dem Substrat zwischen 2 cm und 30 cm beträgt und wobei die Normale zur Substratoberfläche in einem Winkel von mindestens 70° in Bezug auf die Normale zur Targetoberfläche an der "Rennbahn-Erosion" angeordnet ist, die auf ihrer Oberfläche aufgrund von Sputtern in einer MS-OAD-Konfiguration entsteht;
c) Herstellen eines Vakuums in der Kammer von Schritt (b), bis ein Basisdruck von 4-10⁻⁶ mbar oder weniger erreicht ist, Einleiten von Ar-Gas mit einer Strömung zwischen 20 und 40 Standardkubikzentimetern pro Minute und einem Prozessdruck von 5·10⁻³ mbar und Zünden des Magnetronplasmas durch Anlegen einer gepulsten Gleichstromleistung zwischen 50 W und 3000 W und einer Frequenz zwischen 80 und 200 kHz an das Target, während sich der Halter mit einer Drehzahl zwischen 1 und 10 Umdrehungen pro Minute dreht, wodurch eine Schicht der NiFe-Elektrokatalysatorelektrode abgeschieden wird;
und optional
d) Abscheiden oder Erzeugen einer Schicht aus Ni(Fe)OₓH_{y}-Verbindung auf der in Schritt (d) erhaltenen elektrokatalytischen Elektrode aus einer Schichtmetalllegierung durch ein Verfahren, das aus MS-OAD oder durch elektrochemisches Zyklisieren der Elektrode ausgewählt ist.

9. Verfahren nach Anspruch 8, wobei das oder die Nickel/Eisen-Target/s ein Nickel mit einer aus einer Scheibe, einem Quadrat, einem Zylinder und einem Rechteck ausgewählten Form ist, mehr bevorzugt mit einer kreisförmigen Form mit einem Durchmesser zwischen 50 und 100 mm, wobei Eisenstreifen mit einer Breite zwischen 1 mm und 2 mm und einer Dicke zwischen 0,2 und 0,3 mm axial auf die Scheibenoberfläche gewickelt sind.

10. Metallelektrodenanordnung, **dadurch gekennzeichnet, dass** sie zwei Elektroden umfasst, wobei mindestens eine der Elektroden die in einem der Ansprüche 1 bis 7 beschriebene elektrokatalytische Elektrode aus einer Schichtmetalllegierung ist.

11. Metallelektrodenanordnung nach Anspruch 10, wobei
• eine der Elektroden die elektrokatalytische Elektrode aus einer Schichtmetalllegierung ist und geeignet ist, als Anode zu fungieren; und
• die zweite Elektrode eine poröse Ni-Schicht ist, die als Elektrokatalysator fungiert und nach dem gleichen MS-OAD-Verfahren auf eine andere Gasdiffusionsschicht und ein Stromkollektormaterial abgeschieden wird, das als Kathode fungieren kann;
wobei die Anordnung zwischen Anode und Kathode durch eine Anionenaustauschermembran erfolgt und die Elektroden an einen externen Stromkreis angeschlossen sind, der die gewünschte Spannungsdifferenz zwischen Anode und Kathode anlegt, im Allgemeinen von 1,5 bis 2,5 V.

12. AEMWE-Elektrolyseur, **dadurch gekennzeichnet, dass** er eine Stapelung von mindestens zwei MEA-Einheiten nach einem der Ansprüche 10 oder 11 umfasst, die elektrisch in einem kompakten System in Reihe geschaltet sind.

13. AEMWE-Elektrolyseur nach Anspruch 12, wobei er ferner eine Stapelung von mehr als fünf MEA umfasst, die in einem kompakten System so angeordnet sind, dass die Elektroden elektrisch in Reihe geschaltet sind und der Elektrolyt parallel durch die verschiedenen Anoden- und Kathodenkammern zirkuliert und die Gase getrennt durch die Einlass- und Auslassschläuche freigesetzt werden.

14. Verfahren zur Wasserstoffproduktion, **dadurch gekennzeichnet, dass** es die folgenden Schritte umfasst
i. Versorgen des in einem der Ansprüche 10 oder 11 beschriebenen Anionenaustauschmembran-Wasserelektrolyseurs mit einer KOH-Lösung zwischen 0,1 M und 4 M bei einer Temperatur zwischen 40 °C und 85 °C, wobei die Temperatur in Schritt i) vorzugsweise zwischen 60 und 80° liegt;
ii. Anlegen einer Polarisationsspannung zwischen 1,8 V und 2,2 V an jede der in dem Stapel elektrisch in Reihe geschalteten Metallelektroden-Einheitszellen.

15. Verwendung der elektrokatalytischen Elektrode aus einer Schichtmetalllegierung nach einem der Ansprüche 1 bis 7 als Anode in Wasserelektrolyseuren.

## Revendications

1. Électrode électrocatalyseur à couches comprenant
• une couche de diffusion de gaz macroporeuse et un substrat de matériau collecteur de courant dans la plage d'épaisseur de 0,05 à 1,0 mm ; et
• un électrocatalyseur d'une épaisseur équivalente entre 0,05 pm et 5 pm, dans lequel ladite couche d'électrocatalyseur comprend une première et une seconde surface, dans lequel la première surface est en contact avec la surface du substrat, et dans lequel la seconde surface est opposée à la première surface dans la direction définie par l'épaisseur de la couche électrocatalytique ;
caractérisé parce que
le substrat est choisi parmi le papier carbone, l'acier inoxydable ou le nickel, dans lesquels le papier carbone, l'acier inoxydable et le nickel se présentent sous la forme de microfibres, d'une éponge ou d'une structure en forme de maille ;
dans lequel la couche d'électrocatalyseur comprend un alliage de NiFe avec une valeur moyenne comprise entre 0,5 % et 30 % en poids de Fe dans l'alliage, dans lequel la composition d'alliage de NiFe de la première surface de la couche d'électrocatalyseur est comprise entre 0,5 % et 2 % en poids de Fe dans l'alliage, et la composition d'alliage de NiFe de la couche d'électrocatalyseur au niveau de la seconde surface est comprise entre 12 % et 30 % en poids de Fe dans l'alliage ;
dans lequel la couche d'électrocatalyseur a une surface active électrochimique spécifique comprise entre 1 et 100 cm²/mg par rapport à la réaction de dégagement d'oxygène exprimée en surface par unité de charge de catalyseur déterminée à partir des tracés de Nyquist des systèmes d'électrodes au moyen d'une mesure par spectroscopie d'impédance électrique ;
dans lequel la couche d'électrocatalyseur est une couche mésoporeuse avec une porosité totale comprise entre 20 % et 50 % mesurée par isotherme d'adsorption de gaz Kr et avec une taille de pore variant entre 2 et 100 nm déterminée par quantification directe sur des images de microscopie électronique à balayage des films.

2. Électrode d'électrocatalyseur à couches selon la revendication 1, dans laquelle le substrat macroporeux en tant que couche de diffusion de gaz de support et collecteur de courant est du nickel ayant la forme d'une structure en forme de maille.

3. Électrode d'électrocatalyseur à couches selon l'une quelconque des revendications 1 ou 2, dans laquelle la stoechiométrie de l'alliage dans la couche d'électrocatalyseur a une composition homogène de la première surface à la seconde surface ; ou dans laquelle la stoechiométrie de l'alliage dans la couche d'électrocatalyseur a un gradient de composition linéaire du pourcentage en poids de Fe dans l'alliage dans la direction de l'épaisseur de la couche de la première surface en contact avec le substrat GDL à la seconde surface à l'extérieur des zones externes.

4. Électrode d'électrocatalyseur à couches selon l'une quelconque des revendications 1 à 3, dans laquelle l'alliage de NiFe a une valeur moyenne comprise entre 8 % et 12 % en poids de Fe dans l'alliage.

5. Électrode d'électrocatalyseur à couches selon l'une quelconque des revendications 1 à 4, dans laquelle la composition d'alliage NiFe de la première surface de la couche d'électrocatalyseur est comprise entre 0,1 % et 2 % en poids de Fe dans l'alliage, et au niveau de la seconde zone externe est comprise entre 10 % et 20 % en poids de Fe dans l'alliage.

6. Électrode d'électrocatalyseur à couches selon l'une quelconque des revendications 1 à 5, dans laquelle la porosité de la couche d'électrocatalyseur a une porosité constante sur toute l'épaisseur de la couche avec une valeur comprise entre 20 et 50 % du volume total de la couche ; ou dans laquelle la porosité dans la couche d'électrocatalyseur varie linéairement de la première surface à la seconde surface.

7. Électrode électrocatalyseur à couches selon l'une quelconque des revendications 1 à 6, dans laquelle la seconde surface de l'électrocatalyseur comprend en outre une couche d'un composé Ni(Fe)OₓH_{y}.

8. Un procédé pour obtenir l'électrode d'électrocatalyseur à couches selon l'une quelconque des revendications 1 à 7, caractérisé parce qu'il comprend les étapes suivantes
a) placer une couche de diffusion de gaz macroporeuse et un substrat de matériau collecteur de courant choisi parmi le papier carbone, l'acier inoxydable ou le nickel, dans lequel le papier carbone, l'acier inoxydable et le nickel se présentent sous la forme de microfibres, d'une éponge ou d'une structure de type maille en tant que substrat dans un support d'une chambre à vide d'un appareil de dépôt par pulvérisation cathodique à magnétron ;
b) placer du nickel et du fer comme cible ou cibles, ou une cible en alliage NiFe dans la tête de pulvérisation magnétron située dans l'appareil de dépôt de l'étape (a), dans lequel la cible a une forme choisie parmi un disque, un cercle, un carré, un cylindre et un rectangle, et dans lequel la distance entre la cible et le substrat est comprise entre 2 cm et 30 cm et dans lequel la normale à la surface du substrat est située à un angle d'au moins 70° par rapport à la normale à la surface de la cible au niveau de la piste de course formée sur sa surface en raison de la pulvérisation dans une configuration MS-OAD ;
c) faire le vide dans la chambre de l'étape (b) jusqu'à ce qu'une pression de base de 4-10⁻⁶ mbar ou moins soit atteinte, introduire du gaz Ar à un débit compris entre 20 et 40 centimètres cubes standard par minute et une pression de procédure de 5·10⁻³ mbar et allumer le plasma magnétron en appliquant une puissance CC pulsée comprise entre 50 W et 3000 W et une fréquence comprise entre 80 et 200 kHz à la cible pendant que le support tourne à une vitesse de rotation comprise entre 1 et 10 tours par minute, ce par quoi une couche de l'électrode d'électrocatalyseur NiFe est déposée ;
et éventuellement
d) déposer ou générer sur l'électrode électrocatalyseur à couches obtenue à l'étape (d) une couche de composé Ni(Fe)OₓH_{y} par une technique sélectionnée parmi MS-OAD ou par cyclage électrochimique de l'électrode.

9. Procédé selon la revendication 8, dans lequel la ou les cibles nickel/fer sont un nickel de forme choisie parmi le disque, le carré, le cylindre et le rectangle, plus préférentiellement de forme circulaire de diamètre compris entre 50 et 100 mm avec des bandes de fer de largeur comprise entre 1 mm et 2 mm et d'épaisseur comprise entre 0,2 et 0,3 mm, enroulées axialement sur la surface du disque.

10. Ensemble d'électrodes métalliques caractérisé parce qu'il comprend deux électrodes, au moins une desdites électrodes est l'électrode d'électrocatalyseur à couches décrite dans l'une quelconque des revendications 1 à 7.

11. Un ensemble d'électrodes métalliques selon la revendication 10, dans lequel
• l'une des électrodes est l'électrode d'électrocatalyseur à couches, et elle convient pour agir comme une anode ; et
• la deuxième électrode est une couche de Ni poreuse agissant en tant qu'électrocatalyseurs et déposée selon la même procédure MS-OAD sur une autre couche de diffusion de gaz de support et un matériau collecteur de courant approprié pour agir en tant que cathode ;
dans lequel l'assemblage entre anode et cathode est réalisé par une membrane échangeuse d'anions et les électrodes sont connectées à un circuit électrique externe appliquant la différence de tension souhaitée entre anode et cathode, généralement de 1,5 à 2,5 V.

12. Electrolyseur AEMWE caractérisé parce qu'il comprend un empilement d'au moins deux unités MEA selon l'une quelconque des revendications 10 ou 11 connectées électriquement en série dans un système compact.

13. Electrolyseur AEMWE selon la revendication 12, dans lequel comprend en outre un empilement de plus de cinq MEA agencés dans un système compact de manière à ce que les électrodes soient électriquement connectées en série et que l'électrolyte circule en parallèle à travers les différents compartiments d'anode et de cathode et que les gaz soient libérés séparément à travers les tubulures d'entrée et de sortie.

14. Méthode de production d'hydrogène caractérisé parce que qu'il comprend les étapes suivantes
i. alimenter l'électrolyseur d'électrolyse de l'eau à membrane échangeuse d'ions décrite dans l'une quelconque des revendications 10 ou 11 avec une solution de KOH entre 0,1 M et 4 M à une température comprise entre 40 ^{°C} et 85 °C, de préférence la température à l'étape i) est comprise entre 60 et 80^{e} ;
ii. appliquer une tension de polarisation comprise entre 1,8 V et 2,2 V à chacune des cellules unitaires d'électrodes métalliques, électriquement connectées en série dans l'empilement.

15. Utilisation de l'électrode d'électrocatalyseur à couches selon l'une une quelconque des revendications 1 à 7 comme anode dans des électrolyseurs à eau.
